# EUROPÄISCHE PATENTSCHRIFT

(11) **EP 2 014 720 B1**
(45) Veröffentlichungstag und Bekanntmachung des Hinweises auf die Patenterteilung: **15.09.2010**
(21) Anmeldenummer: 07011288.3
(22) Anmeldetag: 08.06.2007
(51) Int. Cl.: C08L 63/00

(54) **Polymerzusammensetzung**
Polymer compound
Composition de polymères

(43) Veröffentlichungstag der Anmeldung: 14.01.2009
(73) Patentinhaber: Hexion Specialty Chemicals GmbH, 58642 Iserlohn-Letmathe (DE)
(72) Erfinder: Scholten, Jörg, 47475 Kamp Lintfort (DE); Reichwein, Heinz-Gunter, 47475 Kamp Lintfort (DE); Hasson, Tareq, Dr., 52062 Aachen (DE)

(56) Entgegenhaltungen:
- JP-A- 7 173 252
- JP-A- 2004 256 678
- US-A- 4 756 954

## Beschreibung

Die Erfindung betrifft eine Polymerzusammensetzung, die zumindest einen Novolak, zumindest ein Polyepoxid auf der Basis von Bisphenol-A, Tetrabrombisphenol-A und/oder Bisphenol-F und/oder epoxidierten Novolak und weitere Bestandteile sowie Additive enthält, ein Verfahren zu deren Herstellung und Verwendung.

Bei den in der Elekroindustrie verwendeten Laminaten handelt es sich um mit Kunsstoffmaterialien beschichtete Trägermaterialien, die mit einer Metallfolie verpresst sind. Als Kunststofihwterialien werden i.d. Regel Phenol- oder Epoxidharze und als Träger Papier, Vliese, Gewebe aus Glas, Aramid oder auch PTFE verwendet. Als Metallfolie findet Kupferfolie Anwendung.

Aus der JP 2005262591 A ist ein Verfahren zur Herstellung von Leiterplatten bekannt, bei dem eine Mischung enthaltend auf einem Novolak basierenden Cyanatharz, ein Biphenyldimethylen basierendes Epoxyharz und ein Phenoxyharz auf eine Kupferoberfläche aufgebracht werden. Diese beschichteten Kupferfolien werden mit Glasgewebe beschichtet und aufgewickelt. Letztendlich erhalten werden Laminate, die ein gutes Aussehen, Schälfestigkeit, Feuer- und Hitzebeständigkeit aufweisen.

In der JP 2004174730 A wird die Verwendung von Epoxyharzen in Mischung mit Phenoxyharzen zur Vorbehandlung von Kupferfolien offenbart. Dabei wirkt das Phenoxyharz als Flussstopper. Es sollen verbesserte Eigenschaften wie akkurate Schichtdicke, Schälfestigkeit und Wasser- und Wärmebeständigkeit erreicht werden.

Aus der JP 2003105205 A geht eine Mischung aus 100 Teilen Epoxidharz, 63,5 Teilen Phenol-Novolak und 70.1 Teilen Phenoxyharz hervor. Diese Zusammensetzung wird auf eine Polyimdfolie aufgebracht, die zur Herstellung von gedruckten Schaltungen mit hohen dielektrischen Konstanten geeignet ist.

Die JP 2000154356 A beschreibt eine Schicht für Leiterplatten, die 45 Teile Biphenol-A-Epoxidharz, 15 Teile Phenol-Novolak-Epoxidharz, 40 Teile Phenol-Novolak und 15 Teile Phenoxyharz sowie weitere Zusatzstoffe enthalten. Die damit hergestellten Halbleiterbauteile weisen eine verbesserte Bruchbeständigkeit auf.

Leiterplatten die auch noch nach Feuchtigkeitsaufnahme eine gute Wärmebeständigkeit während des Lötens aufweist werden in der JP 08151507 beschrieben. Diese enthalten 100 Teile Epoxidharz (Bisphenol-A-Typ > 60 %), ein Phenol- und/oder Kresol- Novolak und ein Phenoxy-Harz (1,5 bis 10 Teile).

Die JP 07173252 A offenbart eine Zusammensetzung für elektronische Bauteile, die ein Epoxidharz mit einem Gehalt > 60 % Bifunktionalität, einem Novolak und einem Phenoxyharz. Mit einer solchen Zusammensetzung wurde Glasgewebe imprägniert, getrocknet und die entstandenen Prepregs mit Metallfolien verpresst. Die Leiterplatten haben eine gute Flammbeständigkeit. Auch hier wurde das Phenoxyharz als Flussstopper verwendet.

Aus der JP 2005290029 A geht hervor, dass Glasfasermaterialien mit einer Zusammensetzung enthaltend ein Bisphenol-A-Epoxidharz, ein bromieretes Bisphenol-A-Epoxidharz, ein Kresol-Novolak-Epoxidharz, ein Novolak und ein Phenoxyharz beschichtet werden und anschließend mit Kupferfolien verpresst werden. Diese Laminate zeigen eine gute Lötstellenbeständigkeit.

Einige der genannten Entgegenhaltungen offenbaren die Verwendung einer Mischung von Bisphenol-A-Novolak, einem Epoxidharz und eines Phenoxyharzes als Kunststoffmaterial zur Aufbringung auf ein Glasmaterial zur Herstellung von Elektrolaminaten. Allerdings hat sich herausgestellt, dass die Verwendung einer bloßen Mischung aus diesen Bestandteilen als Imprägnierung für Glasmaterialien Unzulänglichkeiten in der Haftung zum Glas aufwiesen.

Es ist daher Aufgabe der vorliegenden Erfindung, ein Kunststoffmaterialen zur Herstellung von Elektrolaminaten bereitzustellen, die eine verbesserte Haftung zum Glas besitzen.

Gelöst wird diese Aufgabe erfindungsgemäß durch eine Polymerzusammensetzung, die zundest einen Novolak, zumindest ein Polyepoxid auf der Basis von Bisphenol A, Tetrabrombisphenol-A und/oder Bisphenol F und/oder epoxidierten Novolak und als weiteren Bestandteil 1 bis 15 Gewichtsprozent bezogen auf die gesamte Mischung eines Phenoxypolymers aufweist und durch zumindest folgende Schritte hergestellt ist:
(I) Vermischen des Polyepoxides und des Phenoxypolymers,
(II) Erhitzen der Mischung aus Schritt (I) auf eine Temperatur von 70 °C bis 170 °C in einem Zeitraum von 20 Minuten bis 6 Stunden und anschließend Abkühlen der Mischung,
(III) Zugabe des Novolaks in einem Verhältnis von 20:80 bis 50:50 bezogen auf das Polyepoxid und vermischen,
(IV) gegebenenfalls Mischung aus Schritt (III) verdünnen und
(V) gegebenenfalls Zugabe von weiteren Additiven.

Durch diese Umsetzung wird eine Polymerzusammensetzung erhalten, die eine ausgezeichnete interlaminare Haftung zu Festigkeitsträgern aus Glas aufweist. Festgestellt wurde außerdem, dass die erfindungsgemäße Polymerzusammensetzung auch eine sehr gute Haftung zu Aramid besitzt.

Für die Herstellung der erfindungsgemäßen Polymerzusammensetzung werden ein oder mehrere Polyepoxid(e) auf Basis von Bisphenol A und/oder Bisphenol F, Tetrabrombisphenol-A und/oder epoxidierter Novolak, wie z. B. epoxidierter Tetraphenyloethannovolak, verwendet. Sie haben in der Regel ein Epoxidäquivalentgewicht von 170 bis 500 g.

Als weitere Komponente enthält die erfindungsgemäße Polymerzusammensetzung 1 bis 15 Gewichtsprozent bezogen auf die gesamte Mischung ein Phenoxypolymer bevorzugt mit folgender Struktur:

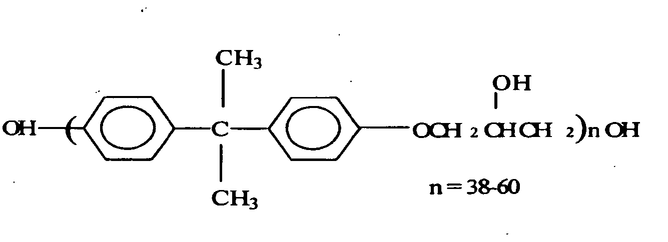

Werden mehr als 15 Gewichtsprozent an Phenoxyharz zugesetzt, werden die Fließeigenschaften der Mischung gebremst, was zu einer inhomogenen Struktur des hergestellten Laminates führt.

Die erfindungsgemäße Polymerzusammensetzung enthält weiterhin zumindest einen Novolak, insbesonere einen Bisphenol-A-Novolak, einen Phenol-Novolak, einen o-Kresol-Novolak, einen Triazin-Novolak und/oder einen Alkylnovolak ist. Die Zugabe des Novolaks erfolgt in einem Verhältnis von 20:80 bis 50:50 bezogen auf das feste Polyepoxid. Die Mischung enthält demnach 20-50 Gewichtsteile Novolak und 50 bis 80 Gewichtsteile Polyepoxid bezogen auf diese beiden Komponenten. Werden mehr als 80 Gewichtsteile Polyepoxid zugesetzt, wird keine ausreichende Aushärtung des Laminates erzielt, bei weniger als 50 Gewichtsteile wurde eine zu geringe Aushärtung festgestellt, die zu verschlechterten mechanischen Eigenschaften führten.

Besonders bevorzugt ist, wenn der Novolak zur Herstellung der erfindungsgemäßen Polymerzusammensetzung in gelöster Form vorliegt, wodurch die Verarbeitung während der Herstellung der Polymerzusammensetzung erleichtert wird. So kann z.B. eine 50-70 %-ige Bisphenol-A-Novolaklösung (gelöst in Alkohohle, Ketone, Methoxyalkohole) verwendet werden.

Als Additive können der Polymerzusammensetzung 1 bis 40 Gew.% bezogen auf den Festharzanteil Additive zugesetzt werden. Diese sind u.a. Farbstoffe, Verarbeitungshilfsmittel, Flammschutzmittel, Füllstoffe. Als besonders bevorzugt werden 10 bis 30 Gew.% einer reaktiven Phosphorkomponente zugegeben, um einen halogenfreien und somit umweltfreundlichen Flammschutz zu gewährleisten. Weiterhin bevorzugt ist, wenn der Polymerzusammensetzung bevorzugt 20 bis 30 Gew.% mineralische Füllstoffe (z.B. Alumioniummonohydrate, AIOOH, Al(OH)3, SiO2 zugegeben werden. Durch die Zugabe der mineralischen Füllstoffe wird der Ausdehnungskoeffizient in z-Achse gering halten, was bei elektronischen Bauteilen sehr gewünscht ist.

Erfindungswesentlich ist die Herstellungsmethode der erfindungsgemäßen Polymerzusammensetzung. Erst durch die speziellen Verfahrensschritte, nämlich
- Vermischen des oder der Polyepoxide(s) und 1 bis 15 Gew.% bezogen auf die gesamte Mischung eines Phenoxypolymers
- Erhitzen der Mischung aus Schritt (I) auf eine Temperatur von 70 °C bis 170 °C in einem Zeitraum von 20 Minuten bis 6 Stunden und anschließend Abkühlen der Mischung,
- Zugabe des oder der Novolaks(e) in einem Verhältnis von 20:80 bis 50:50 bezogen auf das Polyepoxid und vermischen,
- gegebenenfalls Mischung aus Schritt (III) verdünnen und
- gegebenenfalls Zugabe von weiteren Additiven,
werden die gewünschten Eigenschaften erzielt.

Sowohl die Temperaturführung als auch die Zeit für die Herstellung der erfindungsgemäßen Polymerzusammensetzung ist sehr wichtig. Werden 170 °C überschritten setzt ein Gelierprozess ein, der unerwünscht ist. Umsetzungen bei Temperaturen < 70 °C führen zu unzureichenden Ausbeuten, was auch bei einer Reaktionszeit < 20 Minuten der Fall ist. Von besonderem Vorteil ist, wenn die Mischung auf eine Temperatur von 110 °C bis 130 °C in einem Zeitraum von 2,5 bis 3,5 Stunden erhitzt wird. Durch diese gezielten Reaktionsbedingungen kann die erfindungsgemäße Polymerzusammensetzung am rationellsten hergestellt werden.

Die Herstellung der erfindungsgemäßen Polymerzusammensetzung kann in handelsüblichen Aggregaten erfolgen. So werden das Polyepoxid und das Phenoxypolymer unabhängig von der Reihenfolge miteinander vermischt. Bevorzugt liegen diese Komponenten in flüssiger Form vor. Als Lösungsmittel können alle hierzu geeigneten wie z.B. Alkoxyalkohole verwendet werden. Es ist aber auch möglich Festharze zu verwenden. Diese Mischung wird entsprechend erhitzt, und anschließend wieder abgekühlt (bevorzugt auf ca. 30 bis 40 °C) und weiterverarbeitet. Diese Mischung ist aber auch bei Raumtemperatur lagerstabil, was von technologischem und logistischem Vorteil ist. Anschließend wird der Novolak - wie bereits erwähnt- bevorzugt in flüssiger Form zugegeben. Es erfolgt das Vermischen der Komponenten im bevorzugten Temperaturbereich zwischen 20 °C und 40 °C. Die erhaltene Mischung kann gegebenenfalls verdünnt werden hierzu eignen sich Lösungsmittel wie Ketone, Alkohole und/oder Glykolether. Die Zugabe von weiteren Additiven kann ebenfalls nunmehr erfolgen.

Die erfindungsgemäße Polymerzusammensetzung kann nunmehr auf die Oberfläche eines Substrates aufgebracht werden. Das Substrat ist bevorzugt Glas, wiederum bevorzugt in Form von Fasern, Gelegen, Gewirken oder Geweben.

Es ist aber auch möglich, dass das Substrat eine Naturfaser (Cellulose, Baumwolle) in Form z.B. von Fasern, Gelegen, Gewirken oder Geweben ist. Die erfindungsgemäße Polymerzusammensetzung wurde auch auf Aramid aufgebracht und positiv getestet.

Erfindungsgemäß wird eine hervorragende Haftung zwischen Polymerzusammensetzung und Substraten erzielt ohne dass dabei andere Eigenschaftsverschlechterungen wie z.B. im Tg-Wert verzeichnet wurden.

Die erfindungsgemäße Polymerzusammensetzung wird vorzugsweise zur Herstellung von Laminaten und zwar sowohl von Polymer/Papier- als auch von Polymer/Glasgewebe-Laminaten eingesetzt. Weiterhin kann die erfindungsgemäße Polymerzusammensetzung auch für Faserverbundwerkstoffe oder Elektrogießharze verwendet werden.

Besonders erwähnenswert ist, dass die Haftung der Polymerzusammensetzung zu Kupferoberflächen ebenfalls erhöht wird, was insbesondere bei der Herstellung von Elektrolaminaten von besonderer Bedeutung ist, so dass die erfindungsgemäße Polymerzusammensetzung hierfür besonders geeignet ist.

Anhand eines Ausführungsbeispiels soll die Erfindung näher erläutert werden.

### Beispiel 1

11,4 Gewichtsteile eines epoxidierten Bisphenol-A(BPA)-Novolakes, 12,8 Gewichtsteile eines epoxidierten BPA Harzes, 19,9 Gewichtsteile eines epoxidierten Tetrabrombisphenol-A(TBBA) Harzes, 4,3 Gewichtsteile eines epoxidierten Tetraphenylolethannovolakes sowie 4,5 Gewichtsteil 1-Methoxy-2-Propanol werden mit 3,7 Gewichtsteilen Phenoxyharz unter stetigem Rühren versetzt und auf 120°C erhitzt. Die Temperatur wird 2,5 h beibehalten. Der Mischung werden nun 8,4 Gewichtsteile Ethylmethylketon zugegeben und dabei wird die Mischung auf 40°C gekühlt und nach erreichen der 40°C 35,0 Gewichtsteile an BPA-Novolak 65 %-ig, in Ethylmethylketon gelöst, zugegeben. Die erhaltene Mischung wird gerührt und auf 20 - 30°C gekühlt. Anschließend werden 15,0 Gewichtsteile an AlOOH zugegeben und eindispergiert.

### Beispiel 2 (Vergleichsbeispiel)

11,4 Gewichtsteile eines epoxidierten BPA-Novolakes, 12,8 Gewichtsteile eines epoxidierten Bisphenol-A- Harzes, 19,9 Gewichtsteile eines epoxidierten TBBA Harzes, 4,3 Gewichtsteile eines epoxidierten Tetraphenylolethannovolakes werden mit 4,5 Gewichtsteil 1-Methoxy-2-Propanol unter stetigem Rühren versetzt und auf 120°C erhitzt. Die Temperatur wird 1 h beibehalten. Der Mischung werden nun 8,4 Gewichtsteile Ethylmethylketon zugegeben und dabei wird die Mischung auf 40°C gekühlt und nach erreichen der 40°C 35,0 Gewichtsteile an BPA-Novolak 65 %-ig in Ethylmethylketon gelöst und 3,7 Gewichtsteile Phenoxyharz zugegeben. Die Mischung wird 2 Stunden bei < 40°C gelöst. Die erhaltene Mischung wird gerührt und auf 20 - 30°C gekühlt. Anschließend werden 15,0 Gewichtsteile an AIOOH zugegeben und eindispergiert.

### Beispiel 3 (Vergleichsbeispiel)

11,4 Gewichtsteile eines epoxidierten BPA-Novolakes, 12,8 Gewichtsteile eines epoxidierten BPA Harzes, 19,9 Gewichtsteile eines epoxidierten TBBA Harzes, 4,3 Gewichtsteile eines epoxidierten Tetraphenylolethannovolakes sowie 4,5 Gewichtsteile 1-Methoxy-2-Propanol werden mit 3,7 Gewichtsteilen Phenoxyharz unter stetigem Rühren versetzt und auf 120°C erhitzt. Die Temperatur wird 15 Minuten beibehalten. Der Mischung werden nun 8,4 Gewichtsteile Ethylmethylketon zugegeben und dabei wird die Mischung auf 40°C gekühlt und nach erreichen der 40°C 35,0 Gewichtsteile an BPA-Novolak 65 %-ig in Ethylmethylketon gelöst zugegeben. Die erhaltene Mischung wird gerührt und auf 20 - 30°C gekühlt. Anschließend werden 15,0 Gewichtsteile an AIOOH zugegeben und eindispergiert.

### Prepregprozess:

Jeweils 100 Gewichtsteile der Polymerzusammensetzungen aus den Beispielen 1-3 werden mit 30,0 - 35,0 Gewichtsteilen Ethylmethylketon bei Raumtemperatur gemischt. Die B-Zeit wird mit 0.2 - 0,3 Gewichtsteilen einer 10 %-igen 2-Methylimidazollösung in 1-Methoxy-2-Propanol auf 250 - 280 Sekunden bei 170°C eingestellt.

Die Mischung wird mittels einer Imprägnieranlage auf ein Glasgwebe der Type 7628 mit einem Harzgehalt von 42,0 % imprägniert und im Trocknungsofen der Anlage bei 170 - 200°C Lösemittel abgedampft als auch das Polymermaterial vorreagiert. Die Vorreaktion des Prepregs wird auf eine Prepreg-Restgelierzeit von 50 - 80 Sekunden gemessen bei 170°C und eine Prepreg-Minimumviskosität von 20 - 50 Pas bei 140°C gemessen eingestellt. Der Flüchte-Gehalt im Prepreg liegt dabei typischerweise unter 0,4 % im Prepreg.

### Laminatprozess:

Es werden 8 Prepregs mit einer Kupferfolie der Starke von 35µm der Type HWS-HTE in einer Laminatpresse bei 180°C für 90 Minuten bei 7 bar Pressdruck mit einer Autheizrate von 5 K/min verpresst.

### Messmethodenbeschreibungen:

### - Kupferhaftfestigkeit:

Ein 25 mm breiter und 100 mm langer Streifen der Kupferfolie wird auf 20 mm Länge vom Glashartgewebe gelöst und mittels einer geeigneten Vorrichtung mit einer Abzugsgeschwindigkeit von 50 mm/min senkrecht abgezogen. Gemessen wird hierzu die Kraft F (N).

### - Interlaminare Haftung:

Ein 25 mm breiter und 100 mm langer Streifen der obersten 3 Prepreglagen wird auf 20 mm Länge von den anderen 5 Prepreglagen des Glashartgewebes gelöst und mittels einer geeigneten Vorrichtung mit einer Abzugsgeschwindigkeit von 50 mm/min senkrecht abgezogen. Gemessen wird hierzu die Kraft F (N).

### - Brennbarkeitseinstufung nach UL-94:

Der Brennbarkeitstest der nach UL 94 klassifizierten Materialien wurde entsprechend des "Standard for Flammability Tests of Plastic Materials in Devices and Appliances"

### - Lötbadbeständigkeit:

Die Prüfung erfolgte nach DIN IEC 249 Teil 1, Abschnitt 3.7, unter Verwendung eines Lötbades nach Abschnitt 3.7.2.3. Es wurden Probekörper der Größe 25 mm x 25 mm verwendet, die mit der Kupferseite auf das Lötbad gelegt wurden. Es darf keine Delaminierung sowie keine Bildung von Measlings, Flecken oder Blasen unter der Kaschierung auftreten.

### - T-288 Test:

Eine einseitig kupferkaschierte Laminatprobe wird in der TMA Mettler TC 10 A (thermomechanische Analyse) einer Temperatur von 288 °C ausgesetzt. Der Temperaturbereich für die Messung liegt bei 20 - 300°C mit einer Aufheizrate von 20 K/min. Es wird die Zeit bis zur Delaminierung des Laminates gemessen.

### - High Pressure Cooker Test:

Der Test wurde durchgeführt entsprechend der Standard-Test-Methode IPC-TM-650 2.6.16. Auf der Skale von 1 bis 5 bedeutet 1 große Blasen, Measlings oder Oberflächenerosion und 5 keine Blasen, Measlings oder Oberflächenerosion.

### - T_{G} DSC:

Messung an Mettler DSC 821 E mit 10 K/min Autheizrate im Temperaturbereich von 20 - 250°C. DIN EN 61006

### - Laminatdicke:

Die Laminatdicke wird mittels Dickenmessgerät des Herstellers Frank gemessen. Die Messgenauigkeit liegt hierbei bei 1/10mm - 1/100mm.

### Eigenschaften der hergestellten Laminate:

**Tabelle 1**

| **Eigenschaften** | **Probe nach 1)** | **Probe nach 2)** | **Probe nach 3)** |
|---|---|---|---|
| Laminatdicke | 1,58 mm | 1,58 mm | 1,58 mm |
| Kupfer-Haftfestigkeit | 1,6 N/mm | 1,2 N/mm | 1,2 N/mm |
| Interlaminare Haftung | 1,7 N/mm | 0,8 N/mm | 0,8 N/mm |
| Brennbarkeitseinstufung nach UL-94 | V-0 | V-0 | V-0 |
| Lötbadbeständigkeit bei 288 °C | ok | ok | ok |
| T-288 Test | > 30 Minuten | 20 Minuten | 20 Minuten |
| High-Pressure-Cooker Test nach 60 min, 125 °C | Ok | Ok | Ok |
| Tg (DSC) | 175-180°C | 175 -180°C | 175 -180°C |

Aus den Ergebnissen geht hervor, dass durch die spezielle Art des Herstellungsprozesses der Polymerzusammensetzung aus Beispiel 1 eine signifikante Verbesserung der Laminateigenschaften in Bezug auf Kupferhaftung, interlaminare Haftung sowie T-288 Test aufweist ohne einen negativen Einfluss auf die Glasübergangstemperatur zu haben.

## Patentansprüche

1. Polymerzusammensetzung, die zumindest einen Novolak, zumindest ein Polyepoxid auf der Basis von Bisphenol-A, Tetrabrombisphenol-A und/oder Bisphenol-F und/oder epoxidierter Novolak und weitere Bestandteile sowie Additive enthält, **dadurch gekennzeichnet, dass** sie als weiteren Bestandteil 1 bis 15 Gewichtsprozent bezogen auf die gesamte Mischung eines Phenoxypolymers aufweist und durch zumindest folgende Schritte hergestellt ist:
(I) Vermischen des Polyepoxides und des Phenoxypolymers,
(II) Erhitzen der Mischung aus Schritt (I) auf eine Temperatur von 70 °C bis 170 °C in einem Zeitraum von 20 Minuten bis 6 Stunden und anschließend Abkühlen der Mischung,
(III) Zugabe des Novolaks in einem Verhältnis von 20:80 bis 50:50 bezogen auf das Polyepoxid und vermischen,
(IV) gegebenenfalls Mischung aus Schritt (III) verdünnen und
(V) gegebenenfalls Zugabe von weiteren Additiven.

2. Polymerzusammensetzung nach Anspruch 1, **dadurch gekennzeichnet dass** die Mischung auf eine Temperatur von 110 °C bis 130 °C in einem Zeitraum von 2,5 bis 3,5 Stunden erhitzt wird.

3. Polymerzusammensetzung nach Anspruch 1, **dadurch gekennzeichnet dass** das Phenoxypolmer folgende Struktur aufweist:

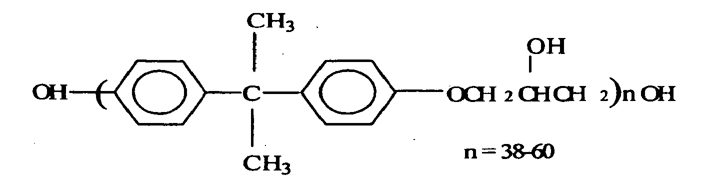

4. Polymerzusammensetzung nach zumindest einem der vorhergehenden Ansprüche, **dadurch gekennzeichnet, dass** der Novolak ein Bisphenol-A-Novolak, ein Phenol-Novolak, ein o-Kresol-Novolak, ein Triazin-Novolak und/oder ein Alkylnovolak ist.

5. Polymerzusammensetzung nach zumindest einem der vorhergehenden Ansprüche, **dadurch gekennzeichnet, dass** die Zusammensetzung 1 bis 40 Gew.% bezogen auf den Festharzanteil Additive enthält.

6. Polymerzusammensetzung nach zumindest einem der vorhergehenden Ansprüche, **dadurch gekennzeichnet, dass** die Zusammensetzung als Additiv zumindest eine reaktive Phosphorkomponente enthält.

7. Polymerzusammensetzung nach zumindest einem der vorhergehenden Ansprüche, **dadurch gekennzeichnet, dass** die Zusammensetzung als Additiv mineralische Füllstoffe aufweist.

8. Polymerzusammensetzung nach zumindest einem der vorhergehenden Ansprüche, **dadurch gekennzeichnet, dass** im Schritt (IV) als Lösungsmittel Ketone, Alkohole und/oder Glykolether zum Einsatz kommen.

9. Polymerzusammensetzung nach zumindest einem der vorhergehenden Ansprüche, **dadurch gekennzeichnet, dass** der Novolak vor dem Vermischen in gelöster Form vorliegt.

10. Verfahren zur Herstellung einer Beschichtung einer Oberfläche eines Substrates mit einer Polymerzusammensetzung, die zumindest einen Novolak, zumindest ein Polyepoxid auf der Basis von Bisphenol-A, Tetrabrombisphenol-A und/oder Bisphenol-F und/oder epoxidierter Novolak und weitere Bestandteile sowie Additive aufweist, folgende Schritte enthaltend:
(I) Vermischen des Polyepoxides und 1 bis 15 Gew% bezogen auf die gesamte Mischung eines Phenoxypolymers,
(II) Erhitzen der Mischung aus Schritt (I) auf eine Temperatur von 70 °C bis 170 °C in einem Zeitraum von 20 Minuten bis 6 Stunden und anschließend abkühlen der Mischung,
(III) Zugabe des Novolaks in einem Verhältnis von 20:80 bis 50:50 bezogen auf das Polyepoxid und vermischen,
(IV) gegebenenfalls Mischung aus Schritt (III) verdünnen und
(V) gegebenenfalls Zugabe von weiteren Additiven und
(VI) Aufbringung der nach den Schritten (I) bis (V) hergestellten Polymerzusammensetzung auf die Oberfläche des Substrates.

11. Verfahren nach Anspruch 10, **dadurch gekennzeichnet, dass** als Substrat Glas in Form von Fasern, Gelegen, Gewirken oder Geweben verwendet wird.

12. Verfahren nach Anspruch 10, **dadurch gekennzeichnet, dass** als Substrat Naturfasern in Form von Gelegen, Gewirken oder Geweben verwendet wird.

13. Substrat, dessen Oberfläche die Polymerzusammensetzung nach zumindest einem der Ansprüche 1 bis 9 aufweist.

14. Laminat für die Leiterplattenindustrie, die Polymerzusammensetzung nach zumindest einem der vorhergehenden Ansprüche 1 bis 9 enthaltend.

## Claims

1. Polymer composition comprising at least a novolak, at least a polyepoxide based on bisphenol A, tetrabromobisphenol A and/or bisphenol F and/or epoxidized novolak and further constituents and also additives, **characterized in that** it includes as a further constituent 1 to 15 weight per cent based on the entire mixture of a phenoxy polymer and is prepared by at least the steps of:
(I) mixing the polyepoxide and the phenoxy polymer together,
(II) heating the mixture from step (I) to a temperature of 70°C to 170°C over a period of 20 minutes to 6 hours and then cooling the mixture,
(III) adding the novolak in a ratio of 20:80 to 50:50 based on the polyepoxide and mixing together,
(IV) optionally diluting the mixture from step (III), and
(V) optionally adding further additives.

2. Polymer composition according to Claim 1, **characterized in that** the mixture is heated to a temperature of 110°C to 130°C over a period of 2.5 to 3.5 hours.

3. Polymer composition according to Claim 1, **characterized in that** the phenoxy polymer has the following structure:

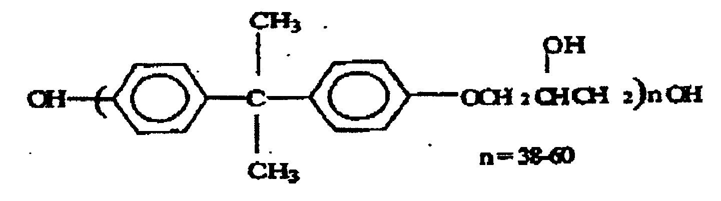

4. Polymer composition according to at least one of the preceding claims, **characterized in that** the novolak is a bisphenol A novolak, a phenol novolak, an o-cresol novolak, a triazine novolak and/or an alkyl novolak.

5. Polymer composition according to at least one of the preceding claims, **characterized in that** the composition comprises 1% to 40% by weight based on the solid resin fraction of additives.

6. Polymer composition according to at least one of the preceding claims, **characterized in that** the composition comprises at least one reactive phosphorus component as additive.

7. Polymer composition according to at least one of the preceding claims, **characterized in that** the composition includes mineral fillers as additive.

8. Polymer composition according to at least one of the preceding claims, **characterized in that** ketones, alcohols and/or glycol ethers are used as solvent in step (IV).

9. Polymer composition according to at least one of the preceding claims, **characterized in that** the novolak is present in dissolved form prior to the mixing together.

10. Process for preparing a coating on a surface of a substrate with a polymer composition which includes at least a novolak, at least a polyepoxide based on bisphenol A, tetrabromobisphenol A and/or bisphenol F and/or epoxidized novolak and further constituents and also additives, comprising the steps of:
(I) mixing the polyepoxide and 1 to 15% by weight based on the entire mixture of a phenoxy polymer together,
(II) heating the mixture from step (I) to a temperature of 70°C to 170°C over a period of 20 minutes to 6 hours and then cooling the mixture,
(III) adding the novolak in a ratio of 20:80 to 50:50 based on the polyepoxide and mixing together,
(IV) optionally diluting the mixture from step (III), and
(V) optionally adding further additives, and
(VI) applying the polymer composition prepared according to steps (I) to (V) to the surface of the substrate.

11. Process according to Claim 10, **characterized in that** the substrate used comprises glass in the form of fibres, nonwoven scrims, formed-loop knits or wovens.

12. Process according to Claim 10, **characterized in that** the substrate used comprises natural fibres in the form of nonwoven scrims, formed-loop knits or wovens.

13. Substrate including on its surface the polymer composition according to at least one of Claims 1 to 9.

14. Laminate for the circuit board industry comprising the polymer composition according to at least one of the preceding Claims 1 to 9.

## Revendications

1. Composition polymère, qui contient au moins une novolaque, au moins un polyépoxyde à base de bisphénol-A, de tétrabromobisphénol-A et/ou de bisphénol-F et/ou une novolaque époxydée et d'autres constituants ainsi que des additifs, **caractérisée en ce qu'**elle contient comme autre constituant 1 à 15% en poids, par rapport à la totalité du mélange, d'un polymère phénoxy et est préparée par au moins les étapes suivantes :
(I) mélange du polyépoxyde et du polymère phénoxy,
(II) chauffage du mélange de l'étape (I) à une température de 70°C à 170°C en un laps de temps de 20 minutes à 6 heures, puis refroidissement du mélange,
(III) addition de la novolaque dans un rapport de 20:80 à 50:50 par rapport au polyépoxyde et mélange,
(IV) le cas échéant, dilution du mélange de l'étape (III) et
(V) le cas échéant addition d'autres additifs.

2. Composition polymère selon la revendication 1, **caractérisée en ce que** le mélange est chauffé à une température de 110°C à 130°C en un laps de temps de 2,5 à 3,5 heures.

3. Composition polymère selon la revendication 1, **caractérisée en ce que** le polymère phénoxy présente la structure suivante :

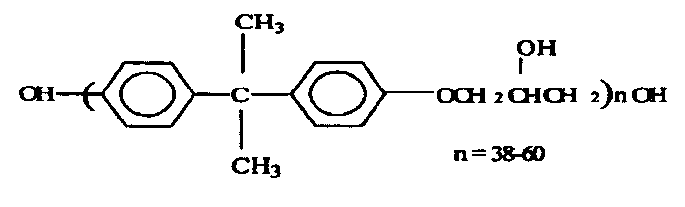

4. Composition polymère selon au moins l'une quelconque des revendications précédentes, **caractérisée en ce que** la novolaque est une bisphénol-A-novolaque, une phénol-novolaque, une o-crésol-novolaque, une triazine-novolaque et/ou une alkylnovolaque.

5. Composition polymère selon au moins l'une quelconque des revendications précédentes, **caractérisée en ce que** la composition contient 1 à 40% en poids, par rapport à la proportion de résine solide d'additifs.

6. Composition polymère selon au moins l'une quelconque des revendications précédentes, **caractérisée en ce que** la composition contient comme additif au moins un composé réactif du phosphore.

7. Composition polymère selon au moins l'une quelconque des revendications précédentes, **caractérisée en ce que** la composition présente, comme additif, des charges minérales.

8. Composition polymère selon au moins l'une quelconque des revendications précédentes, **caractérisée en ce qu'**on utilise, dans l'étape (IV), comme solvant, des cétones, des alcools et/ou des glycoléthers.

9. Composition polymère selon au moins l'une quelconque des revendications précédentes, **caractérisée en ce que** la novolaque se trouve sous forme dissoute avant le mélange.

10. Procédé pour la préparation d'un revêtement d'une surface d'un substrat avec une composition polymère, qui contient au moins une novolaque, au moins un polyépoxyde à base de bisphénol-A, de tétrabromobisphénol-A et/ou de bisphénol-F et/ou une novolaque époxydée et d'autres constituants ainsi que des additifs, contenant les étapes suivantes :
(I) mélange du polyépoxyde et de 1 à 15% en poids par rapport à la totalité du mélange d'un polymère phénoxy,
(II) chauffage du mélange de l'étape (I) à une température de 70°C à 170°C en un laps de temps de 20 minutes à 6 heures, puis refroidissement du mélange,
(III) addition de la novolaque dans un rapport de 20:80 à 50:50 par rapport au polyépoxyde et mélange,
(IV) le cas échéant, dilution du mélange de l'étape (III) et
(V) le cas échéant addition d'autres additifs et
(VI) application de la composition polymère préparée selon les étapes (I) à (V) sur la surface du substrat.

11. Procédé selon la revendication 10, **caractérisé en ce qu'**on utilise comme substrat du verre sous forme de fibres, de non-tissés, de tricots ou de tissus.

12. Procédé selon la revendication 10, **caractérisé en ce qu'**on utilise comme substrat des fibres naturelles sous forme de non-tissés, de tricots ou de tissus.

13. Substrat, dont la surface présente la composition polymère selon au moins l'une quelconque des revendications 1 à 9.

14. Laminé pour l'industrie des circuits imprimés, contenant la composition polymère selon au moins l'une quelconque des revendications précédentes 1 à 9.
